# EUROPÄISCHE PATENTSCHRIFT

(11) **EP 2 594 023 B1**
(45) Veröffentlichungstag und Bekanntmachung des Hinweises auf die Patenterteilung: **13.08.2014**
(21) Anmeldenummer: 11724630.6
(22) Anmeldetag: 09.06.2011
(51) Int. Cl.: H03K 17/96

(54) **OPTISCHES BEDIENELEMENT, INSBESONDERE TASTER ODER SCHALTER**
OPTICAL USER DEVICE, PUSH BUTTON OR SWITCH
MANIPULATEUR OPTIQUE, BOUTON-POUSSOIR OU INTERRUTPEUR

(30) Priorität: 14.04.2011 DE 202011000870 U; 16.07.2010 DE 102010027499
(43) Veröffentlichungstag der Anmeldung: 22.05.2013
(73) Patentinhaber: Mechaless Systems GmbH, 76646 Bruchsal (DE)
(72) Erfinder: SCHWENINGER, Erhard, 76149 Karlsruhe (DE); HASE, Michael, 69168 Wiesloch (DE)
(74) Vertreter: Durm & Partner
(86) Internationale Anmeldenummer: PCT/EP2011/059598
(87) Internationale Veröffentlichungsnummer: WO 2012/007236

(56) Entgegenhaltungen:
- EP-A1- 0 777 327
- DE-A1-102005 021 008
- US-A- 5 811 791

## Beschreibung

Die vorliegende Erfindung betrifft ein optisches Bedienelement, insbesondere einen Taster oder einen Schalter, mit einem Lichtsender, einem optischen Empfänger, einem zur Lichtleitung geeigneten Prisma und mit einer Abdeckung, die strahlungsundurchlässig ist und wenigstens eine Austrittsöffnung aufweist.

In vielen elektronischen Geräten, wie z. B. Mobiltelefonen, Fernbedienungen, Haushaltsgeräten, Aufzügen und in der Automobilindustrie werden häufig Berührungsschalter oder -taster eingesetzt, die bei einem Berühren durch den Benutzer einen Schaltvorgang im Gerät auslösen. Dabei sind sowohl kapazitive als auch optische Schalter z.B. aus der Druckschrift DE 10 2005 021 008 A1 bekannt. Im Falle eines kapazitiven Berührungsschalters weist dieser eine Sensorfläche auf, die als Teil eines kapazitiven Sensorelements gemeinsam mit dem Benutzer eine Kapazität bilden, die sich durch das Berühren entsprechend verändert. Die Sensorfläche ist dabei üblicherweise über eine Messelektrode mit einer Schaltungsanordnung gekoppelt, die einer Auswerteschaltung ein entsprechendes Ausgangssignal zuführt. Aus diesem kann bestimmt werden, ob der kapazitive Berührungssensor betätigt wird oder nicht.

Die kapazitiven Messverfahren weisen jedoch nur geringe Reichweiten auf und sind im Wesentlichen auf eine direkte Berührung begrenzt. Soll die Reichweite dieses Sensors erhöht werden, so reagieren die Sensoren in der Regel fehlerhaft oder zumindest unerwünscht auf Feuchtigkeit, Temperaturänderungen oder elektromagnetische Störstrahlung. Darüber hinaus funktionieren diese Sensoren nicht bei umgebenden, leitfähigen Oberflächen, wie Metall oder Metallisierungen.

Neben kapazitiven Bedienelementen sind auch optische Bedienelemente bekannt, bei denen die Reflexion von Licht im sichtbaren oder nicht sichtbaren Bereich, insbesondere im Infrarotbereich, ausgenutzt wird. Damit ist es möglich, nicht nur die Berührung, sondern auch die Annäherung eines Objekts, beispielsweise eines Fingers, zu erkennen, in dem die Veränderungen der Quantität des reflektierten Lichts erkannt und ausgewertet wird. Durch die Analyse des reflektierten Lichts wird eine Änderung des reflektierten Lichts erkannt und löst dann einen Schaltvorgang oder einen ähnlichen Vorgang aus. Zwar weisen die auf optischen Messverfahren beruhenden Bedienelemente größere Reichweiten auf, sie haben jedoch häufig den Nachteil, dass sie zumeist durch Fremdlicht gestört werden. Darüber hinaus benötigen sie einen bestimmten Bauraum hinter der Bedienoberfläche, um die Sensoren (Photoempfänger) zu positionieren. Sie setzen stets eine Bedienoberfläche voraus, die derart lichtdurchlässig ist, dass genügend Licht ausgestrahlt und ein genügend großer Anteil an reflektiertem Licht empfangen und dem optischen Sensor zugeführt werden kann.

Optische Sensoren verwenden vorzugsweise LEDs als Lichtquellen und Lichtsensoren. Als Empfänger werden Photodioden oder Photoelemente eingesetzt. Photodioden weisen für moduliertes Licht eine von der absoluten Helligkeit abhängige Sensitivität auf, den sogenannten Ambient-Light-Effekt. Somit hängt das Empfangssignal einer Reflexionslichtschranke nicht nur von dem zu messenden Reflexionsgrad, sondern auch von dem Umgebungslicht ab. Die Auswertung des Empfangssignals ist bei stark schwankenden Umgebungslichtverhältnissen nicht mehr zuverlässig möglich. Die JP 2006-164672 A zeigt einen optischen Sensor, der hinter einem Spiegel angeordnet ist. Der Spiegel weist in seiner Silberfolie einige Öffnungen auf, hinter denen ein optisches Prisma zur Lichtleitung und Beleuchtung des Sensors angeordnet ist. Der optische Sensor ist derart angeordnet, dass Licht direkt durch eine der Öffnungen der Silberfolie ausgestrahlt und das von einem sich annähernden Objekt reflektierte Licht von einem direkt hinter der Öffnung positionierten Empfänger empfangen wird. Sender und Empfänger sind direkt nebeneinander angeordnet, so dass es zu einem Übersprechen kommt und die Empfindlichkeit des Sensors derart stark reduziert ist, dass ein Annähern eines Objekts an den Sensor nicht zuverlässig erkannt werden kann.

Aus der EP 0 706 648 B1 ist ein Messverfahren bekannt, bei dem die Übertragungsfunktion der Photodiode eliminiert wird. Wenigstens zwei Lichtquellen senden abwechselnd auf wenigstens einen Empfänger Licht aus. Die Lichtquellen sind derart geregelt, dass sie aus Sicht des Empfängers stets gleich hell leuchten. Somit ist das Empfangssignal der Photodiode für beide Signale gleich groß. Senden die beiden Lichtquellen ein gegenphasiges rechteckförmiges Lichtsignal, so ergibt sich durch Regelung der Messstrecke ein Empfangssignal von Null. Dies hat zur Folge, dass die Verstärkung des Empfängers nahezu beliebig hoch gewählt werden kann, da nur das bandpaßgefilterte Empfangssignal bewertet wird. Ist eine der Lichtquellen zu stark, so erkennt dies die nachfolgende Schaltung und regelt die Intensität der Lichtquelle entsprechend nach, bis das Differenzsignal der beiden Lichtquellen am Empfänger wieder gleich Null ist.

Die EP 1 671 160 B1 offenbart ein Verfahren zur Bestimmung und Auswertung eines differenziellen, optischen Signals. Dieses Verfahren beruht auf der EP 0 706 648 B1 und weist zusätzlich eine Kompensationslichtquelle auf, um die gewonnene Regelgröße wieder in die Regelstrecke einzubringen.

Die auf Reflexion beruhenden optischen Sensoren setzen stets eine Sensor-oberfläche voraus, durch die ein ausreichender Teil an Licht austreten kann. Im Stand der Technik besteht ein großer Bedarf an optischen Bedienelementen, bei denen die Sensoroberfläche, die als Funktions- oder Tastenfläche dient, nur einen sehr geringen Lichttransmissionsgrad aufweisen. Dies kann beispielsweise darauf beruhen, dass Materialien mit geringem Transmissionsgrad verwendet werden oder Materialien, die hohe Streuwerte aufweisen, so dass ein außerhalb des Materials reflektierter Lichtstrahl nicht mehr ausgewertet werden kann. Häufig sollen auch aus ästhetischen Gründen Sensoroberflächen verwendet werden, die einen Aufdruck oder eine Maske mit einer Aussparung aufweisen. Beispielsweise werden Sensoroberflächen aus Metallblechen, metallisierten Folien oder mit Metallbedampfungen verwendet, in denen Zeichen oder Symbole ausgespart sind. Es gibt auch Oberflächen, die lackiert sind und bei denen durch Maskenbildung Symbole erkennbar sind. Diese Aussparungen oder Masken in den nicht durchlässigen Oberflächen erlauben den Austritt von Licht. Sie sind häufig aber sehr klein, so dass die herkömmlichen optischen, auf Reflexion beruhenden Messverfahren nicht eingesetzt werden können, da die Sensoroberflächen selbst zu hohe Dämpfungswerte aufweisen. Auch sind solche Bedienflächen oft für kapazitive Messverfahren oder andere Messverfahren grundsätzlich nicht geeignet. Zudem sollen die Tasten häufig durch eine Lichtquelle von hinten beleuchtet werden, so dass die Form der Aussparung auf der Oberfläche leuchtet.

Aus dem Stand der Technik ergibt sich die Aufgabe, verbesserte optische Bedienelemente zu schaffen, die auf der Reflexionsmessmethode beruhen und lichtundurchlässige Oberflächen mit geringen Maskierungen aufweisen.

Gelöst wird die vorliegende Aufgabe durch ein optisches Bedienelement mit den Merkmalen des Anspruchs 1 und durch ein Verfahren nach Anspruch 16.

Das erfindungsgemäße optische Bedienelement, das insbesondere einen Schalter oder ein Taster sein kann, hat einen Licht ausstrahlenden Lichtsender, einen optischen Empfänger, eine Kompensationslichtquelle, eine Auswerteschaltung, ein zur Lichtleitung geeignetes Prisma und eine Abdeckung. Das Prisma hat eine Seitenfläche, die eine aktive Sensorfläche ist, und ist derart unterhalb der Abdeckung angeordnet, dass die aktive Sensorfläche des Prismas im Wesentlichen parallel zur Unterseite der Abde-ckung ausgerichtet ist. Der Bereich der Abdeckung, der oberhalb der aktiven Sensorfläche angeordnet ist und mit der aktiven Sensorfläche des Prismas korrespondiert, ist der Sensorbereich der Abdeckung. Dieser Sensorbereich der Abdeckung weist einen Transmissionsgrad von höchstens 99% auf. Bevorzugt ist der Transmissionsgrad höchstens 95% oder höchstens 90%, besonders bevorzugt höchstens 80% oder höchstens 50%.

Die Abdeckung selbst hat bevorzugt einen geringen Transmissionsgrad von höchstens 20%, höchstens 15% oder höchstens 10%, bevorzugt von höchstens 5% oder höchstens 2%. Sie kann auch im Wesentlichen strahlungsundurchlässig sein und weist dann bevorzugt wenigstens eine Austrittsöffnung auf, so dass der gesamte Transmissionsgrad der Abdeckung inklusive der Austrittsöffnungen die obigen Werte aufweist. Der Lichtsender ebenso wie die Kompensationslichtquelle kann eine Lichtquelle, beispielsweise eine LED sein. Der optische Empfänger ist bevorzugt ein Lichtsensor, wie z. B. eine Photodiode. Der Lichtsender und der Empfänger arbeiten mit Licht im sichtbaren oder nicht-sichtbaren Bereich, z. B. Infrarot-Bereich.

Unter dem Begriff aktive Sensorfläche ist die Fläche zu verstehen, die zur optischen Auswertung genutzt wird. Durch die aktive Sensorfläche wird das Messlicht ausgesendet und tritt das am zu detektierenden Objekt reflektierte Messlicht in das Prisma ein. Bevorzugt ist die gesamte Seitenfläche des Prismas die aktive Sensorfläche.

Unter dem Begriff zur Lichtleitung geeignetes Prisma wird allgemein ein optischer Körper verstanden, der zur Lichtausbreitung in seinem Inneren geeignet ist. Das Signalprisma (Prisma) ist nicht streuend, so dass das eingekoppelte Licht im Inneren des Prismas geradlinig von einer Begrenzungsfläche zu einer gegenüberliegenden Begrenzungsfläche geleitet wird und dort - je nach Auftreffwinkel auf die Begrenzungsfläche - reflektiert oder transmittiert wird. Als Prisma sind insbesondere Glaskörper oder formstabile Kunststoffkörper geeignet.

Die Abdeckung besteht aus einem Material mit einer geringen Transmission, wie z.B. einem "Black-Panel-Material" oder einem entsprechenden Kunststoffmaterial. Möglich ist auch die Verwendung eines eingefärbten Materials oder eines stark streuenden Materials, das nur einen kleinen bis vernachlässigbaren transmissiven Anteil aufweist. Die Abdeckung besteht bevorzugt aus einem nicht lichtdurchlässigen Material, wie beispielsweise einem Metallblech, einer metallbedampften oder metallisierten Folie oder einer lackierten Folie. In die Abdeckung ist bevorzugt wenigstens eine Austrittsöffnung eingebracht, so dass Licht durch diese Austrittsöffnung der Abdeckung austreten kann.

Das Prisma ist derart unterhalb der Abdeckung angeordnet, dass eine Begrenzungsfläche des Prismas im Wesentlichen parallel zur Abdeckung verläuft. Der Lichtsender ist relativ zum Prisma so angeordnet, dass ausgestrahltes Licht durch das Prisma geleitet wird und an der der Abdeckung benachbarten Begrenzungsfläche austritt, so dass das Licht durch Abdeckung oder, wenn in einer bevorzugten Ausführungsform vorhanden, durch die Austrittsöffnung der Abdeckung transmittieren kann.

Außerhalb des Bedienelements wird das ausgetretene Licht an einem Objekt, beispielsweise einem Finger, reflektiert, so dass der reflektierte Lichtanteil zurück durch die Abdeckung oder die Austrittsöffnung in das Prisma geleitet wird. Der Empfänger ist derart angeordnet, dass das von dem Objekt außerhalb des Bedienelements reflektierte Licht das Prisma durchläuft und dem Empfänger zugeführt wird. Eine Änderung der Reflexion wird in einer angeschlossenen Auswerteschaltung erkannt und als Schalten interpretiert.

Vorteilhaft ist hierbei, dass die Abdeckung selbst die gewünschte Form und eine nicht lichtdurchlässige Oberfläche aufweisen kann. Die Abdeckung kann stark streuend sein. Wichtig ist jedoch, dass das verwendete Prisma nicht streuend ist und den Lichtstrahl im Wesentlichen geradlinig weiterleitet.

Soll eine Hinterleuchtung des Bedienelements erfolgen, so weist das optische Bedienelement ein Diffusorelement auf, das zum Streuen von eingestrahltem Licht verwendet wird. Damit wird sichergestellt, dass die gesamte Austrittsöffnung der Abdeckung möglichst gleichmäßig mit Licht beschienen wird. Auf diese Weise ist es möglich, die Austrittsöffnung zu beleuchten, so dass die Taste bzw. das optische Bedienelement auch im Dunkeln erkannt werden kann.

In einer bevorzugten Ausführungsform weist die Abdeckung mehrere Austrittsöffnungen auf. Die Austrittsöffnungen sind dabei derart gewählt, dass die Summe ihrer Öffnungsflächen deutlich geringer ist als die Fläche der Abdeckung des optischen Bedienelements. Somit ist auch die Flächensumme aller Austrittsöffnungen deutlich kleiner als die Fläche der Begrenzungsfläche (Seitenfläche) des Prismas, die der Abdeckung benachbart ist. Bevorzugt ist die Summe der Öffnungsflächen der Austrittsöffnungen höchstens 50 Prozent der Fläche der Abdeckung bzw. der Begrenzungsfläche des Prismas, besonders bevorzugt höchstens 30 Prozent, höchstens 20 Prozent oder höchstens 10 Prozent.

Ausführungsformen mit Austrittsöffnungen, die in Summe eine Fläche aufweisen, die höchstens sieben Prozent der Fläche der Abdeckung entspricht, ist ebenfalls bevorzugt. Das erfindungsgemäße optische Bedienelement kann auch dann noch zuverlässig arbeiten, wenn die Summe der Öffnungsflächen der Austrittsöffnungen höchstens 5 Prozent, bevorzugt höchstens 3 Prozent, sehr bevorzugt höchstens 2 Prozent der Fläche der Abdeckung entspricht. Unter bestimmten Umständen kann dieses Verhältnis auch lediglich höchstens 1 Prozent oder 0,5 Prozent betragen.

Ausgehend von einer Grundfläche von 10 mm x 10 mm (100 mm²) der Abdeckung ist die Summenfläche aller Austrittsöffnungen bevorzugt höchstens 10 mm², 7 mm² , 6 mm², 5 mm², 3 mm², 2 mm² oder 1 mm². Das erfindungsgemäße Bedienelement arbeitet bei diesen Öffnungsflächen immer noch zuverlässig und erkennt jedenfalls ein direkt kontaktierendes Objekt. Bei derartigen Öffnungsflächen liegt der Gesamt-Transmissionsgrad der Abdeckung einschließlich der Austrittsöffnungen bei höchstens 20% bis höchstens 5%, teilweise auch bei weniger, z.B. bei höchstens 3%, 2% oder 1%. Das erfindungsgemäße Bedienelement arbeitet auch dann noch zuverlässig.

Die Austrittsöffnungen in der Abdeckung sind so gestaltet, dass wenigstens eine der Austrittsöffnungen vorzugsweise die Form eines Symbols, einer Zahl, eines Buchstabens oder eines Piktogramms aufweist. Es ist auch möglich, dass mehrere Austrittsöffnungen gemeinsam ein Symbol, eine Zahl, einen Buchstaben oder ein Piktogramm bilden. Ebenfalls ist es denkbar, dass mehrere Buchstaben durch einzelne oder mehrere Austrittsöffnungen gebildet werden. Beispielsweise können im Automobilbereich die dort vorhandene Piktogramme bzw. Symbole oder auch Abkürzungen wie ABS, DTC, ESP und Ähnliches durch einzelne oder mehrere Austrittsöffnungen erzeugt werden.

Um insbesondere im Automobilbereich diese Tasten zu hinterleuchten, wird die Austrittsöffnung durch ein Diffusorelement beleuchtet. Dazu kann entweder der Licht ausstrahlende Lichtsensor verwendet werden, wenn er Licht im sichtbaren Bereich aussendet. In der Regel wird der Lichtsender jedoch im infraroten, zumindest im nicht sichtbaren Wellenlängenbereich arbeiten, so dass er für die Hinterleuchtung nicht geeignet ist. In diesem Fall ist bevorzugt eine weitere Lichtquelle vorgesehen, die das Diffusorelement derart beleuchtet, dass eine Hinterleuchtung der Taste erfolgt. Die Hinterleuchtung kann farblich an Kundenwünsche angepasst werden. Es ist auch möglich, mehrere Lichtquellen zur Hinterleuchtung zu verwenden. Denkbar sind auch Lichtquellen, die durch gezielte Ansteuerung ihre Farbe ändern. Beispielsweise könnte sich beim Erkennen der Annäherung eines Objekts, beispielsweise eines Fingers, an das optische Bedienelement die Farbe der Taste ändern.

In einer bevorzugten Ausführungsform ist das Diffusorelement derart angeordnet, dass das lichtleitende Prisma zwischen der Abdeckung und dem Diffusorelement angeordnet ist. Das diffus aus dem Diffusorelement austretende Licht wird dann durch das Prisma geradlinig weitergeleitet, wobei eine gleichmäßige Beleuchtung der Austrittsöffnungen bzw. der dargestellten Symbole gewährleistet ist. Die Hinterleuchtung stört die eigentliche Messung nicht. Wie oben erwähnt, kann sie sogar das Messsignal oder Teil des Messsignals sein.

In einer bevorzugten Ausführungsform ist das Prisma keilförmig ausgebildet. Beispielsweise kann das Prisma als optische Sonderform des geometrischen Körpers "Prisma" verstanden werden. Es ist dann ein gerades Prisma mit einer dreieckigen Grundfläche. Alternativ und ebenfalls bevorzugt ist ein Prisma, das eine keilartige Form hat. Bevorzugt ist hierbei ein Prisma, bei dem zwei Begrenzungsflächen des Prismas einen Winkel von 90 Grad einschließen. Besonders bevorzugt ist die Grundfläche des Prismas ein gleichschenkliges rechtwinkliges Dreieck.

Bei dem keilförmigen Prisma ist bevorzugt eine der Begrenzungsflächen parallel zur Abdeckung angeordnet. Die zweite im 90-Grad-Winkel daran anschließende Begrenzungsfläche des Prismas erstreckt sich senkrecht von der Abdeckung weg. An dieser Begrenzungsfläche sind seitlich der Sender und/oder der Empfänger angeordnet. Bevorzugt sind sowohl Sender als auch Empfänger an dieser Seite angeordnet. Bevorzugt liegen Sender und Empfänger nebeneinander oder übereinander. Dies bietet die Möglichkeit, dass die Bautiefe des Bedienelements gering gehalten werden kann, da die optischen Bauteile nicht unterhalb der Austrittsöffnungen platziert werden müssen.

Erfindungsgemäß weist das optische Bedienelement eine Kompensationslichtquelle auf, die bevorzugt als Kompensations-LED ausgeführt ist. Die Auswerteschaltung umfasst eine Kompensationsschaltung. In einer bevorzugten Ausführungsform ist die Kompensations-LED an einer Seite des Prismas angeordnet, die im 90-Grad-Winkel zur Abdeckung und im 90-Grad-Winkel zu der dem Empfänger und Sender benachbarten Begrenzungsfläche angeordnet. Die Kompensationslichtquelle ist derart relativ zu der Empfangsdiode (Photodiode) positioniert, dass sie die Photodiode indirekt bestrahlt. Durch Vergleich des von dem Lichtsender ausgesandten und an einem Objekt reflektierten Lichts mit dem von der Kompensationslichtquelle empfangenen Lichts erfolgt eine Regelung, die die Übertragungsfunktion der Photodiode kompensiert und ausregelt. Näheres zu diesem Verfahren ist aus der EP 1 671 160 B1 und der EP 706 648 B1 bekannt.

Aufgrund der geringen Austrittsöffnungen in der Abdeckung muss die Sensitivität des Sensors groß sein bzw. die, den Lichtsender und die Photodiode umfassende Messanordnung eine geringe Grundkopplung aufweisen. Unter Grundkopplung wird der Teil des Lichts verstanden, der bei nicht vorhandenen Objekten außerhalb des Bedienelementes von dem Lichtsender zum optischen Empfänger zurückgelangt und dort empfangen und ausgewertet wird. Da das optische Messsignal (von dem Sender abgestrahlte Licht) größtenteils nur noch im nicht streuenden Prisma verläuft und keine stark streuenden Schichten durchlaufen muss, wie es in anderen bekannten Lösungsansätzen der Fall ist, kann diese Grundkopplung gering gehalten werden. Nur so lässt sich die hohe Empfindlichkeit erzielen, die erforderlich ist, um die minimalen Änderungen im funktionalen Lichtsignal auflösen zu können.

Im Rahmen der Erfindung wurde erkannt, dass durch entsprechende Bearbeitung der inneren Rückseite der Abdeckung, also der Fläche der Abdeckung, die dem Prisma benachbart ist, die Grundkopplung verbessern kann. Dazu wird diese innere Rückseite derart bearbeitet, dass möglichst wenig Signal reflektiert wird und zur Photodiode zurücktransportiert wird. Das gesamte zur Messung verwendete ausgestrahlte Licht, das nicht durch die Austrittsöffnungen nach außen hindurchtritt, soll möglichst vollständig absorbiert oder jedenfalls nicht in Richtung Photodiode reflektiert werden. Dazu kann die Rückseite der Abdeckung aufgeraut, hinterlegt, hinterklebt oder lackiert werden.

Die Erfindung wird nachfolgend anhand von in den Figuren dargestellten besonderen Ausführungsformen näher erläutert. Die dort dargestellten Besonderheiten können einzeln oder in Kombination verwendet werden, um bevorzugte Ausgestaltungen der Erfindung zu schaffen. Die beschriebenen Ausführungen stellen keine Einschränkung der durch die Ansprüche in ihrer Allgemeinheit definierten Erfindung dar. Es zeigen:
- Fig. 1a - c: Detailansichten eines Bedienelements mit dem Prisma und Diffusorelement;
- Fig. 2: eine alternative Ausführungsform eines Bedienelements mit Diffusorelement;
- Fig. 3: eine weitere alternative Ausführungsform des optischen Bedienelements; und
- Fig. 4: eine Ausführungsform des Bedienelements mit insgesamt vier Tasten, die jeweils wenigstens eine Austrittsöffnung aufweisen.

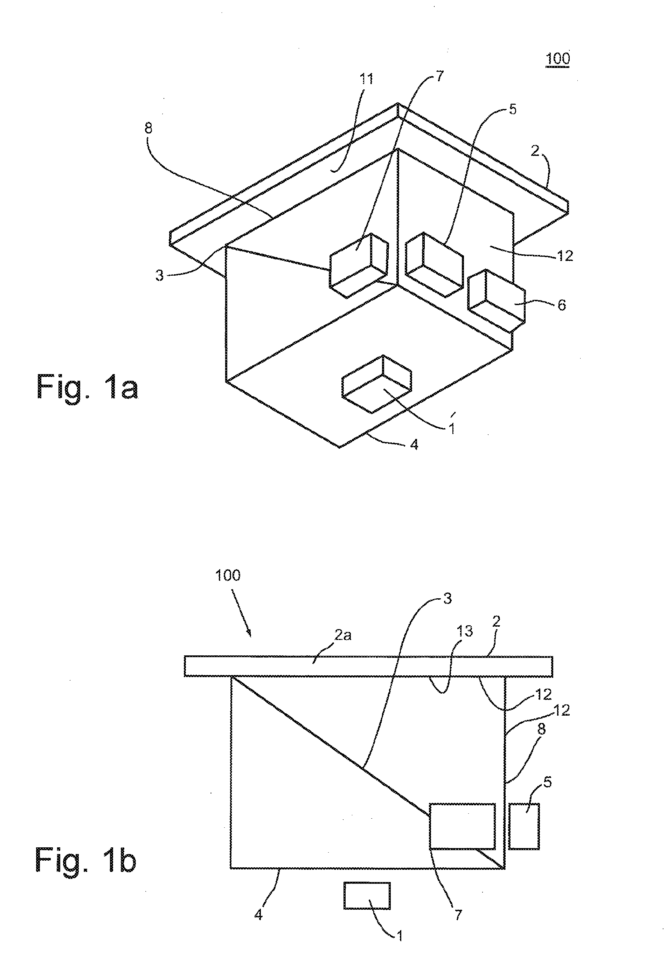

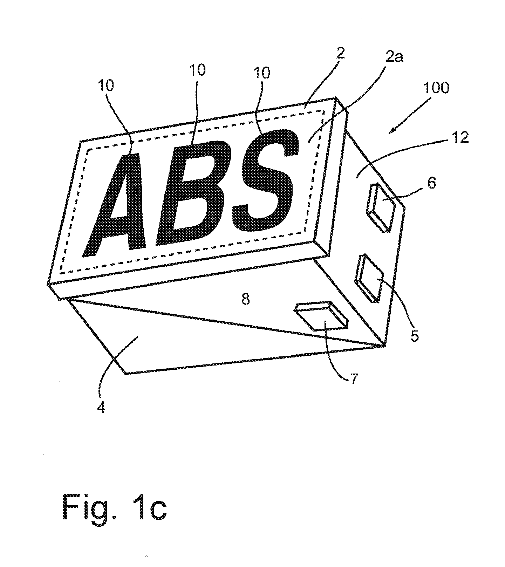

Die Figuren 1a bis c zeigen ein optisches Bedienelement 100 mit einer Abdeckung 2, die gemäß Fig. 1c mehrere Austrittsöffnungen 10 aufweist. Die Austrittsöffnungen 10 bilden das Wort ABS und werden typischerweise im Automobilbereich bzw. im Automotive-Sektor eingesetzt.

An der Unterseite 11 der Abdeckung 2 ist ein Prisma 8 angeordnet, das als Signalprisma ausgebildet ist. Das Signalprisma 8 ist keilförmig, wobei es zwei Seitenflächen 12 aufweist, die einen rechten Winkel einschließen. Eine der Seitenflächen 12 ist eine aktive Sensorfläche 13. Die gesamte Fläche der Sensorfläche 12 ist also die aktive Sensorfläche 13. Sie ist der Abdeckung 2 benachbart. Diese Seitenfläche 12 (aktive Sensorfläche 13) ist parallel zur Unterseite 11 der Abdeckung 2 angeordnet. Bevorzugt liegt die Abdeckung 2 mit ihrer Unterseite an der Seitenfläche 12 des Prismas 8 an. Beide Flächen stehen folglich in Kontakt. Der Bereich der Abdeckung, der mit der aktiven Sensorfläche 13 korrespondiert, ist der Sensorbereich 2a der Abdeckung 2. Die Fläche des Sensorbereichs 2a ist so groß wie die Fläche der aktiven Sensorfläche 13. Der Sensorbereich 2a dient zum Aussenden von Licht und zum Empfangen des ausgesandten und an einem Objekt reflektierten Lichts. Der Sensorbereich 2a ist also der Bereich, der bevorzugt an der Sensorfläche 13 anliegt.

An der zweiten Seitenfläche 12 sind der Lichtsender 5, der als Sender-LED ausgebildet ist, und der Empfänger 6, der als Photodiode ausgebildet ist, angeordnet. Licht, das von der Sender-LED 5 durch das Prisma ausgesendet wird, wird an der Grenzfläche 3 reflektiert und im Prisma 8 in Richtung Abdeckung 2 gelenkt. An der Abdeckung 2 tritt es durch die Austrittsöffnungen 10, die bevorzugt alle im Sensorbereich 2a der Abdeckung 2 angeordnet sind, heraus und kann an einem außerhalb des Bedienelements 100 angeordneten oder angenäherten Objekt reflektiert werden. Das reflektierte Licht tritt durch die Austrittsöffnungen 10 der Abdeckung 2 in die aktive Sensorfläche 13 des Signalprismas 8 ein und wird ebenfalls an der Grenzfläche 3 derart reflektiert, dass es zur Photodiode 6 gelenkt wird. Durch Änderung der Reflexion wird in einer hier nicht gezeigten Auswerteschaltung erkannt, dass ein Objekt angenähert ist, beispielsweise derart, dass die Abdeckung 2 von der Außenseite berührt wird. Diese Änderung wird von der Auswerteschaltung als Betätigen des Bedienelements interpretiert und bewertet. Je nach Ausführungsform des Bedienelements kann es als Taster oder als Schalter arbeiten.

Eine Kompensationslichtquelle 7, die als Kompensations-LED ausgeführt ist, ist an einer der abgeschrägten Seitenflächen des keilförmigen Signalprismas 8 positioniert. Die Kompensations-LED 7 sendet Licht aus, das indirekt (entsprechend abgeschwächt) von der Photodiode 6 empfangen wird. Auf diese Weise ist es möglich, durch Vergleich bzw. durch Regelung der Ansteuerung der Kompensations-LED und der Sender-LED das summierte Empfangssignal auf Null zu regeln. Dabei ist das von der Kompensations-LED ausgesendete Licht um 180 Grad phasenverschoben im Vergleich zu dem von der Sender-LED ausgesendeten Licht. Auf diese Weise ist es möglich, die Übertragungsfunktion der Photodiode 6 und des nachfolgenden, hier nicht gezeigten Verstärkers und der Auswerteschaltung zu kompensieren.

Das erfindungsgemäße Bedienelement 100 hat den Vorteil, dass neben dem nichtstreuenden Signalprisma 8 auch ein Diffusorelement 4 vorhanden ist, das in der in Fig. 1 gezeigten Ausführung als keilförmiger Beleuchtungsdiffusor 4 ausgebildet ist. Eine Beleuchtungsquelle 1, die eine Lichtquelle ist, sendet Licht in den Beleuchtungsdiffusor 4, das diffus aus der aktiven Sensorfläche 13 und aus den Austrittsöffnungen 10 der Abdeckung 2 austritt. Damit wird die gesamte Austrittsöffnungsfläche gleichmäßig beleuchtet. Auf diese Weise ist es möglich, eine beleuchtete Taste zu erzeugen, damit die in Symbol- oder Icon-Form ausgebildeten Austrittsöffnungen 10 sichtbar werden.

Da das Diffusorelement 4 unterhalb des Signalprismas 8 angeordnet ist, wird der optische Weg des von der Sender-LED ausgestrahlten Messlichts nicht durch streuende Medien behindert.

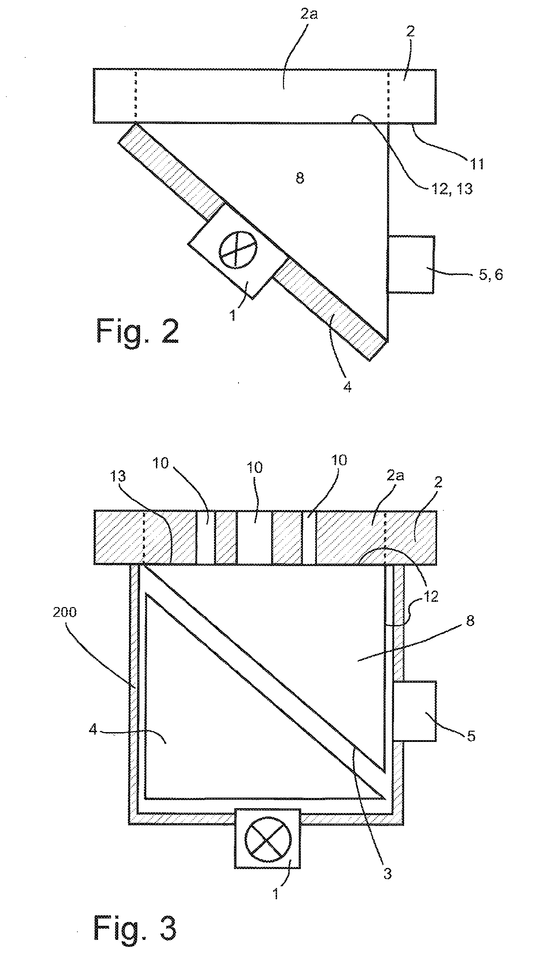

Fig. 2 zeigt einen Querschnitt durch das Bedienelement 100 mit einem keilförmigen Signalprisma 8, einer Abdeckung 2 mit dem Sensorbereich 2a und einem Diffusorelement 4. Die Abdeckung 2 liegt mit seinem Sensorbereich 2a an der die aktive Sensorfläche 13 bildenden Seitenfläche 12 an. Das Diffusorelement 4 ist in diesem Fall als parallele Platte (Quader) angeordnet und liegt an der Grenzfläche 3 des Signalprismas 8 an. Die Lichtquelle 1 ist unterhalb des Diffusorelements 4 angeordnet. In der Regel genügt ein derartiges Diffusorelement um die Taste und die auf der Taste aufgebrachten Symbole in Form von Austrittsöffnungen 10 gleichmäßig zu hinterleuchten. Bei einem nicht keilförmigen Diffusorelement 4 kann die Lichtquelle 1, die bevorzugt ebenfalls eine LED ist, platzsparend positioniert werden.

Fig. 3 zeigt eine Weiterbildung des als Taster ausgeführten Bedienelements 100 aus Fig. 1 als Schnittdarstellung. Das Bedienelement 100 ist in einer Kapselung 200 angeordnet, die bevorzugt die Form eines nach oben offenen Quaders oder Würfels aufweist. An der Unterseite ist eine Öffnung vorgesehen, durch die Licht von der Beleuchtungsquelle 1 in den Diffusor 4 eingestrahlt werden kann. An einer der Seiten sind Öffnungen vorgesehen, hinter denen der Lichtsender 5 und der optische Empfänger 6 angeordnet sind. Durch die Öffnungen wird das Licht von der Sender-LED 5 in das Signalprisma 6 ausgesandt und das reflektierte Licht an der Photodiode 6 hinter der entsprechenden Öffnung empfangen. An einer hier nicht gezeigten Seite ist eine weitere Öffnung vorgesehen, hinter der die Kompensations-LED 7 positioniert wird, um Licht direkt zur Photodiode 6 auszustrahlen.

Das Bedienelement 100 in Fig. 3 ist derart geschnitten, dass die Abdeckung 2 im Bereich der Austrittsöffnungen 10 gezeigt ist. Deutlich sind die einzelnen Austrittsöffnungen 10 zu erkennen, die an der Oberseite ein Icon, ein Symbol oder einen oder mehrere Buchstaben ausbilden.

Zusammenfassend sind die zu lösende technische Aufgabe und die Lösungsmittel sowie die einzelnen Vorteile des erfindungsgemäßen Bedienelements nochmals dargestellt. Dabei wird auf die sogenannte HALIOS-Methode Bezug genommen, die den oben genannten europäischen Patenten EP 1 671 160 B1 sowie EP 706 648 B1 beschrieben sind. Die HALIOS-Methode umfasst eine Kompensationsmethode zur Kompensation der Übertragungsfunktion der Photodiode und der Mess- und Kompensationsschaltung. Näheres ist den entsprechenden Patenten zu entnehmen. Der Begriff HALIOS-Chip ist ein elektronischer Baustein der Firma Elmos, der unter dem geschützten Namen "HALIOS" vertrieben wird.

Die vorliegende Erfindung betrifft das Erkennen eines Objekts, insbesondere einer Hand oder eines Fingers bei der Berührung einer Sensoroberfläche (Taste) sowie bereits vor dieser Berührung, also in größerer Entfernung zur Sensoroberfläche. Dies wird Vorfelderkennung genannt. Damit ist es möglich, Tastenfunktionen zu realisieren und gegebenenfalls Hintergrundbeleuchtungen (gegebenenfalls selektiv) zu steuern. Sobald ein Annähern eins Fingers an die Taste erfolgt, kann beispielsweise die Helligkeit der Hintergrundbeleuchtung erhöht oder abgedimmt werden.

Dabei ist die Licht-Transmission der relevanten Funktions- oder Tastenfläche gering bis sehr gering, sei es durch den Einsatz von Materialien mit geringer Mess-Licht-Transmission und/oder hohen Streuwerten und/oder kleinen transmissiven (insbesondere IR-transparenten) Flächen (Freistellungen) in der Taste überhaupt. Die Sensor-Oberfläche (bzw. die Sensor-Abdeckung) kann mit einem Aufdruck oder einer Aussparung/Maske (Buchstabe, Zahl, Symbol...) versehen werden, wobei insbesondere Metallbleche, (metallisierte) Folien, Metallbedampfung, Lacke oder aber auch Black-Panel-Materialien zum Einsatz kommen, die für herkömmliche optische Messverfahren zu hohe Dämpfungswerte aufweisen oder für andere Messprinzipien, (z.B. das kapazitive) grundsätzlich nicht geeignet sind. Die zu erhaltende Information, ob ein Objekt vorhanden ist oder nicht, ist eine reflexionsgradbasierende Reichweiteninformation. Diese Information bleibt auch dann korrekt erhalten, wenn die Oberfläche von der Rückseite aus beleuchtet wird. Die Hinterleuchtung stört die Messung nicht, sie kann sogar Messsignal oder Teil des Messsignals sein. Weiterhin ist es möglich, eine größere Anzahl von Tasten in einem (unterschiedlich geformten) Feld anzuordnen bzw. zusammenzufassen und alle Funktionen zeitgleich mit einem einzigen HALIOS®-Chip (ggf. zusammen mit einem HALIOS ®-Vorverstärker) zu betreiben.

Hochempfindliche, hinterleuchtete HALIOS-Symboltaste geringer Bauhöhe:

Die eingesetzten passiven optischen Bauteile, welche für die optische Reflexion, optische Kopplung und diffuse Hintergrundbeleuchtung benötigt werden, bestehen aus einem klaren oder auch eingefärbten, auf jeden Fall nicht streuenden Signal-Prisma und einem Beleuchtungsdiffusor. In den Figuren 1a - 1c sind dies die Komponenten 8 bzw. 4. Die Bauteile für die Detektion (Messfunktion) umfassen - gemäß der HALIOS-Methode - eine Sende-LED 5, eine Kompensations-LED 7 und eine Empfangsdiode 6. Sende-LED 5 und empfangende Photodiode 6, sind - wie in der Skizze gezeigt - so am Signal-Prisma angeordnet, dass Ihre durch Totalreflexion abgelenkten Strahlungs-/Empfangskeulen sich an der vollständig hinterseitig ausgeleuchteten Sensor-Oberfläche bzw. Abdeckung 2 praktisch vollkommen überlappen. Außerdem ist die Kompensations-LED 7 durch geeignete Positionierung am Signal-Prisma mit der adäquaten optischen Kopplung in die der HALIOS-Regelschleife eingebunden, um (unter anderem) die nötige Empfindlichkeit (Auflösung) des Sensors zu gewährleisten. Der unter dem Signal-Prisma angebrachte Beleuchtungsdiffusor (z.B. in Keilform oder als Platte) wird von der Rückseite aus durch eine Beleuchtungsquelle 1 angestrahlt, gibt diese Beleuchtung durch das (nicht streuende) Signal-Prisma 8 an die Oberfläche (Symbolfläche) weiter, um diese schließlich (diffus) sichtbar zu hinterleuchten.

Der Beleuchtungsdiffusor 4 und die separate "diskrete" Lichtquelle 1 (alternativ auch mehrere davon) können - je nach Anforderung bezüglich Farbton, Intensität, Erscheinung im ausgeschalteten Zustand und Designfragen im Allgemeinen, aber auch Einschaltdauer - auch in einem einzigen großflächigen Leuchtelement realisiert werden, z.B. mit einer geeigneten (bereits von sich aus homogen leuchtenden) O-LED (organische LED).

Hohe Empfindlichkeit des erfindungsgemäßen Bedienelements über die Reduktion der Grundkopplung:

Dadurch, dass das optische Messsignal größtenteils nur noch im (nicht streuenden) Signal-Prisma verläuft (und nicht mehr stark streuende Schichten durchlaufen muss - wie in anderen Lösungsansätzen), kann die Grundkopplung gering gehalten werden. Dies ist die entscheidende Voraussetzung für die angestrebte hohe Empfindlichkeit, um die minimalen Änderungen im funktionalen Signal aufzulösen zu können. Die Forderung nach geringer Grundkopplung impliziert, dass auch die (innere) Rückseite der Symbolfläche möglichst wenig (Grundkopplungs-) Signal zur Photodiode zurückgibt. D. h. alles gesendete Messlicht, das nicht durch die Austrittsöffnung der Symbolfläche nach außen dringt, muss möglichst vollständig absorbiert oder ggf. nicht in Richtung der Photodiode reflektiert werden. Dafür muss die Symbolrückseite entsprechend bearbeitet (aufgeraut, hinterlegt, hinterklebt, lackiert) werden. Ausreichend homogenes Ausleuchten der Symbolfläche mit Hintergrundlicht und Messlicht gleichermaßen. Dadurch sind geringere Bauhöhen möglich. Durch die räumliche Trennung der Komponenten für die Hinterleuchtung von jenen für die Messtechnik entfällt die (geometrische) Enge, die in einer Anordnung aller Komponenten unterhalb der Symbolfläche (also ohne Signal-Prisma) entstehen würde. Die verschiedenen Bauteile würden sich gegenseitig im Wege stehen, abschatten oder sogar (optisch, elektrisch) beeinflussen und könnten nicht optimal positioniert werden. Diese räumlichen Konflikte lie-ßen sich nur durch größere Bauhöhen entschärfen. Größere Bauhöhen bedeuten ihrerseits wieder längere Lichtwege durch streuende Medien und/oder ungünstigere (weil Grundkopplung produzierende) Winkel, usw.

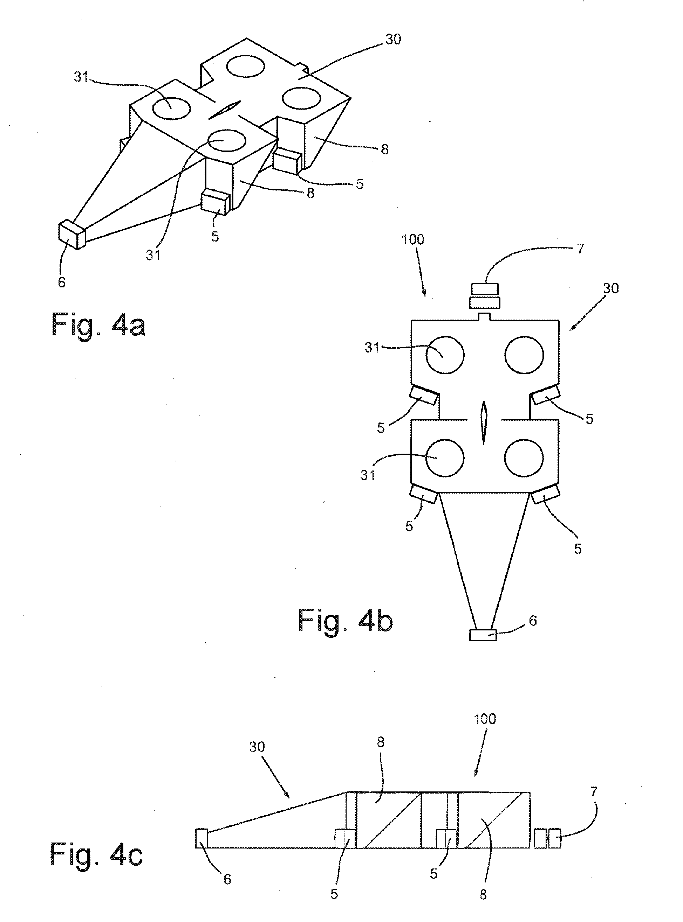

Wenn die Abdeckung 2 mehrere Tasten mit je wenigstens einer Austrittsöffnung umfasst, kann Licht von einem ersten Lichtsender durch eine erste Austrittsöffnung und Licht von einem zweiten Lichtsender durch eine zweite Austrittsöffnung austreten. Fig.4 zeigt eine Ausführungsform des erfindungsgemäßen Bedienelements 100 mit einem Tastenfeld mit insgesamt 4 Tasten. Jede der Tasten kann in der Abdeckung 2 eine oder mehrere Austrittsöffnungen 10 aufweisen, die ein Symbol, einen Buchstaben, einen Schriftzug, eine Zahl oder ein Piktogramm darstellen. Durch mehrfache Zurverfügungstellung der oben beschriebenen (einzelnen) Tastenfunktion innerhalb einer monolithischen oder modularen Lichtleiterstruktur 30 entsteht ein Tastenfeld (Switch-Array), das vollständig und gleichzeitig durch einen (einzigen) HALIOS-Chip ausgewertet werden kann. Dabei entspricht die Anzahl der Sende-LEDs 5 (und der Hinterleuchtungsquellen) genau der Anzahl der Tastenfunktionen. Die Lichtleiterstruktur 30 ist so aufgebaut, dass jeweils ein Prisma 8 unterhalb einer Taste 31 angeordnet ist und von der Sende-LED 5 ausgestrahltes (sichtbares oder nicht-sichtbares) Licht zu der Taste 31 bzw. durch die Austrittsöffnung 10 der jeweiligen Tastenabdeckung geleitet wird. An einem Objekt reflektiertes Licht wird mittels des Prismas 8 in den Lichtwellenleiter 30 derart eingespeist, dass es zu der Photodiode 6 gelenkt wird. Pro (Gesamt-)Tastenfeld müssen die Photodiode 6, die Kompensations-LED 7 und der HALIOS-Chip nur einmal vorhanden sein. Das hier beispielhaft skizzierte Tastenfeld von 2 x 2 Tasten kann in weiten Grenzen variiert werden. Es sind verschiedene Tasten-Anordnungen möglich, z.B. lineare, gekrümmte, bogenförmige, verschieden gestaltete Oberflächen (Abdeckungen) bzw. Arrays usw. Je nach den gegebenen Randbedingungen (Geometrie, Empfindlichkeit, Reaktionszeit) kann durch Multiplexen der Sendekanäle die Zahl der durch einen einzigen HALIOS-Chip ausgewerteten Kanäle (Tasten) auf acht oder zwölf erhöht werden, gegebenenfalls mittels eines (HALIOS-) Vorverstärkers.

## Patentansprüche

1. Optisches Bedienelement, insbesondere Taster oder Schalter, mit einem Licht ausstrahlenden Lichtsender, einem optischen Empfänger, einer Kompensationslichtquelle, einer Auswerteschaltung, einem zur Lichtleitung geeigneten Prisma und mit einer Abdeckung, wobei
- das Prisma (8) eine Seitenfläche (12) hat, die eine aktive Sensorfläche (13) ist,
- das Prisma (8) derart unterhalb der Abdeckung (2) angeordnet ist, dass die aktive Sensorfläche (13) des Prismas (8) im Wesentlichen parallel zur Unterseite der Abdeckung (2) ausgerichtet ist,
- die Abdeckung (2) einen Sensorbereich (2a) aufweist, welcher der Bereich der Abdeckung (2) oberhalb der aktiven Sensorfläche (13) ist und der einen Transmissionsgrad von höchstens 99%, höchstens 95%, höchstens 90%, höchstens 80% oder höchstens 50% hat,
- das Prisma (8) und der Lichtsender (5) derart angeordnet sind, dass vom Lichtsender (5) ausgestrahltes Licht durch das Prisma (8) geleitet wird und durch die aktive Sensorfläche (13) und die Abdeckung (2) hindurchtritt, **dadurch gekennzeichnet, dass**
- die Kompensationslichtquelle (7) Licht zu dem optischen Empfänger (6) sendet, das in der Auswerteschaltung verarbeitet wird, und
- der Empfänger (6) derart angeordnet ist, dass das ausgestrahlte und an einem außerhalb des Bedienelements angeordneten Objekt reflektierte Licht durch den Sensorbereich (2a) der Abdeckung (2) und die aktive Sensorfläche (13) hineintritt und durch das Prisma (8) zu dem Empfänger (6) geleitet wird und der Empfänger (6) derart ausgebildet ist, dass eine Änderung des an dem Objekt reflektierten Lichts von der Auswerteschaltung erkannt und als Schalten interpretiert wird.

2. Optisches Bedienelement nach Anspruch 1, **dadurch gekennzeichnet, dass** die Abdeckung (2) strahlungsundurchlässig ist und wenigstens eine Austrittsöffnung (10) aufweist, durch die ausgestrahltes Licht hindurchtreten kann, wobei die Austrittsöffnung (10) der Abdeckung (2) eine im Vergleich zur Fläche der Abdeckung (2) wenigstens 50 % kteinere Öffnungsfläche aufweist und der Lichtsender (5) und das Prisma (8) bevorzugt derart angeordnet sind, dass Licht von dem Lichtsender (5) durch die wenigstens eine Austrittsöffnung (10) austritt.

3. Optisches Bedienelement nach Anspruch 1 oder 2, **gekennzeichnet durch** ein Diffusorelement (4) zum Streuen von eingestrahltem Licht, wobei in das Diffusorelement (4) eingestrahltes Licht gestreut **durch** die Austrittsöffnung (10) der Abdeckung (2) austritt und eine Hinterleuchtung des optischen Bedienelements (100) ermöglicht.

4. Optisches Bedienelement nach einem der vorhergehenden Ansprüche, **dadurch gekennzeichnet, dass** die Abdeckung (2) mehrere Austrittsöffnungen (10) aufweist und bevorzugt wenigstens zwei Austrittsöffnungen (10) gemeinsam ein Symbol, einen Buchstaben, eine Zahl oder ein Piktogramm darstellen.

5. Optisches Bedienelement nach einem der vorhergehenden Ansprüche, **dadurch gekennzeichnet, dass** die Summe der Öffnungsflächen der Austrittsöffnungen (10) maximal 30 Prozent der Fläche der Abdeckung (2) ist, bevorzugt, maximal 20 Prozent, 10 Prozent, 7 Prozent, 5 Prozent, 3 Prozent oder 2 Prozent.

6. Optisches Bedienelement nach einem der vorhergehenden Ansprüche, **dadurch gekennzeichnet, dass** die Summe der Offnungsflächen der Austrittsöffnungen (10) maximal 10 mm², 7 mm², 5 mm², 3 mm² oder 2 mm² beträgt.

7. Optisches Bedienelement nach einem der vorhergehenden Ansprüche, **dadurch gekennzeichnet, dass** wenigstens eine der Austrittsöffnungen (10) die Form eines Symbols, einer Zahl, eines Buchstabens oder eines Piktogramms aufweist.

8. Optisches Bedienelement nach einem der vorhergehenden Ansprüche, **gekennzeichnet durch** eine weitere Lichtquelle (1) zur Beleuchtung des optischen Bedienelements (100), wobei die Lichtquelle (1) derart angeordnet ist, dass ihr ausgestrahltes Licht in dem Diffusorelement (4) diffus gestreut wird und anschließend **durch** das Prisma (8) zu der Austrittsöffnung (10) der Abdeckung (2) geleitet wird.

9. Optisches Bedienelement nach einem der Ansprüche 1 bis 8, **dadurch gekennzeichnet, dass** die Licht ausstrahlende Lichtquelle (1) zur Hinterleuchtung des optischen Bedienelements (100) verwendet wird, wobei bevorzugt ein Teil des ausgestrahlten Lichts des Lichtsenders (5) in dem Diffusorelement (4) diffus gestreut wird, bevor der gestreute Teil des Lichts durch die Austrittsöffnung (10) der Abdeckung (2) austritt.

10. Optisches Bedienelement nach einem der vorhergehenden Ansprüche, **dadurch gekennzeichnet, dass** das Prisma (8) keilförmig angeordnet ist, wobei eine der Seitenflächen (12) im Wesentlichen parallel zur Abdeckung (2) angeordnet ist und bevorzugt der Lichtsender (5) und/oder der optische Empfänger (6) an einer der Seiten des keilförmigen Prismas (8) angeordnet ist.

11. Optisches Bedienelement nach Anspruch 10, **dadurch gekennzeichnet, dass** das Prisma (8) ein gerades Prisma (8) mit einer dreieckförmigen Grundfläche ist, wobei zwei Seitenflächen (12) einen rechten Winkel einschließen und eine dieser Seitenflächen (12) parallel zu der Abdeckung (2) angeordnet ist und an der anderen dieser Seitenflächen (12) der Lichtsender (5) und/oder der optische Empfänger (6) angeordnet sind.

12. Optisches Bedienelement nach einem der vorhergehenden Ansprüche, **dadurch gekennzeichnet, dass** die Kompensationslichtquelle (7) als LED ausgebildet ist, die Licht bevorzugt durch das Prisma (8) zu dem optischen Empfänger (6) sendet.

13. Optisches Bedienelement nach dem vorhergehenden Anspruch, **dadurch gekennzeichnet, dass** die Auswerteschaltung eine Kompensationsschaltung umfasst, die es erlaubt, die Position und/oder die Bewegung eines Objektes in der Nähe der Austrittsöffnung (10) der Abdeckung (2) zu erkennen.

14. Optisches Bedienelement nach dem vorhergehenden Anspruch, **dadurch gekennzeichnet, dass** die Abdeckung (2) mehrere Austrittsöffnungen (10) umfasst und Licht von einem ersten Lichtsender (5) durch eine erste Austrittsöffnung (10) und Licht von einem zweiten Lichtsender (5) durch eine zweite Austrittsöffnung (10) austritt.

15. Optisches Bedienelement nach dem vorhergehenden Anspruch, **dadurch gekennzeichnet, dass** der Transmissionsgrad der Abdeckung (2) höchstens 20%, höchstens 15%, höchstens 10%, höchstens 5% oder höchstens 2% ist.

16. Verfahren zur optoelektronischen Erkennung der Bewegung und/oder Position eines Objektes mit einem optischen Bedienelement (100) nach einem der vorhergehenden Ansprüche umfassend die folgenden Schritte:
- Aussenden einer Lichtstrahlung von mindestens einem Lichtsender (5),
- Leiten des ausgestrahlten Lichts durch das Prisma (8) und die Austrittsöffnung (10) der Abdeckung (2), wobei das Licht aus der Austrittsöffnung (10) hindurchtritt,
- Empfangen von zurückgestrahltem Licht durch die Austrittsöffnung (10) infolge eines in der Nähe der Austrittsöffnung (10) außerhalb des Bedienelements (100) bewegten oder positionierten Objekts,
- Leiten der an dem Objekt reflektierten Strahlung durch das Prisma (8) zu dem optischen Empfänger (6),
- Auswerten des optischen Eingangssignals am Empfänger (6) mittels einer Auswerteschaltung zur Bestimmung der Bewegung und/oder der Position des Objekts.

## Claims

1. Optical operating element, particularly pushbutton or switch, comprising a light-radiating light transmitter, an optical receiver, a compensation light source, an evaluation circuit, a prism suitable for guiding light, and having a cover, wherein
- the prism (8) has a side surface (12) that is an active sensor area (13),
- the prism (8) is arranged below the cover (2) in such manner that the active sensor area (13) of the prism (8) is oriented substantially parallel to the underside of the cover (2),
- the cover (2) has a sensor region (2a) that is the region of the cover (2) above the active sensor area (13) and which has a transmittance of at most 99%, at most 95%, at most 90%, at most 80%, or at most 50%,
- the prism (8) and the light transmitter (5) are arranged in such manner that the light emitted by the light transmitter (5) is guided through the prism (8) and passes through the active sensor area (13) and the cover (2),
**characterised in that**
- the compensation light source (7) transmits light to the optical receiver (6), the light being processed in the evaluation circuit, and
- the receiver (6) is arranged in such manner that the transmitted light that is reflected from an object outside the optical operating element and enters the active sensor area (13) through the sensor region (2a) of the cover (2) is guided to the receiver (6) through the prism (8), and the receiver (6) is designed in such manner that a change in the reflection is detected by the evaluation circuit and interpreted as switching.

2. Optical operating element according to claim 1, **characterised in that** the cover (2) is light-impermeable and has at least one exit aperture (10) through which emitted light can pass, wherein the exit aperture (10) of the cover (2) has an aperture area at least 50% smaller than the area of the cover (2), and the light transmitter (5) and the prism (8) are preferably arranged in such manner that light from the light transmitter (5) exits through the at least one exit aperture (10).

3. Optical operating element according to claim 1 or 2, **characterised by** a diffuser element (4) for scattering irradiated light, wherein light that is irradiated into the diffuser element (4) exits in a diffuse manner through the exit aperture (10) of the cover (2) and enables backlighting of the optical operating element (100).

4. Optical operating element according to any one of the preceding claims, **characterised in that** the cover (2) has a plurality of exit apertures (10), and preferably at least two exit apertures (10) together represent a symbol, a letter, a number or a pictogram.

5. Optical operating element according to any one of the preceding claims, **characterised in that** the sum of the aperture areas of the exit apertures (10) does not exceed 30 per cent of the area of the cover (2), preferably does not exceed 20 per cent, 10 per cent, 7 per cent, 5 per cent, 3 per cent, or 2 per cent.

6. Optical operating element according to any one of the preceding claims, **characterised in that** the sum of the aperture areas of the exit apertures (10) is not greater than 10 mm², 7 mm², 5 mm², 3 mm², or 2 mm².

7. Optical operating element according to any one of the preceding claims. **characterised in that** at least one of the exit apertures (10) has the form of a symbol, a number, a letter or a pictogram.

8. Optical operating element according to any one of the preceding claims, **characterised by** an additional light source (1) for illuminating the optical operating element (100), wherein the light source (1) is arranged in such manner that the light emitted thereby is scattered diffusely in the diffuser element (4) and is then guided through the prism (8) to the exit aperture (10) of the cover (2).

9. Optical operating element according to any one of the claims 1 to 8, **characterised in that** the light-emitting light source (1) is used to back-light the optical operating element (100), wherein preferably a portion of the light transmitted by the light transmitter (5) is scattered diffusely in the diffuser element (4) before the scattered portion of the light exits through the exit aperture (10) of the cover (2).

10. Optical operating element according to any one of the preceding claims, **characterised in that** the prism (8) is arranged in the form of a wedge, wherein one of the side surfaces (12) is aligned substantially parallel to the cover (2) and preferably the light transmitter (5) and/or the optical receiver (6) is arranged on one of the sides of the wedge-shaped prism (8).

11. Optical operating element according to claim 10, **characterised in that** the prism (8) is a straight prism (8) with a triangular base area, wherein two side surfaces (12) enclose a right angle, and one of these side surfaces (12) is arranged parallel to the cover (2), and the light transmitter (5) and/or the optical receiver (6) is/are arranged on the other of these side surfaces (12).

12. Optical operating element according to any one of the preceding claims, **characterised in that** the compensation light source (7) is in the form of an LED, which preferably transmits light through the prism (8) to the optical receiver (6).

13. Optical operating element according to the preceding claim, **characterised in that** the evaluation circuit comprises a compensation circuit with which it is possible to detect the position and/or movement of an object in the vicinity of the exit aperture (10) of the cover (2).

14. Optical operating element according to the preceding claim, **characterised in that** the cover (2) comprises a plurality of exit apertures (10), and light from a first light transmitter (5) exits through a first exit aperture (10), and light from a second light transmitter (5) exits through a second exit aperture (10).

15. Optical operating element according to the preceding claim, **characterised in that** the transmittance of the cover (2) is not more than 20%, not more than 15%, not more than 10%, not more than 5%, or not more than 2%.

16. Method for detecting a movement and/or position of an object by opto-electronic means with an optical operating element (100) according to any one of the preceding claims, comprising the following steps:
- emitting a light beam by at least one light transmitter (5),
- guiding the emitted light through the prism (8) and the exit aperture (10) of the cover (2), wherein the light passes through the exit aperture (10),
- receiving light that is returned through the exit aperture (10) as a consequence of an object moving or positioned outside the operating element (100) in the vicinity of the exit aperture (10),
- guiding the beam reflected from the object through the prism (8) to the optical receiver (6),
- evaluating the optical input signal at the receiver (6) by means of an evaluation circuit for determining the movement and/or position of the object.

## Revendications

1. Élément de commande optique, notamment bouton-poussoir ou commutateur, comprenant un émetteur de lumière émettant de la lumière, un récepteur optique, une source lumineuse de compensation, un circuit d'analyse, un prisme conçu pour guider la lumière et un élément de recouvrement,
- le prisme (8) ayant une surface latérale (12) qui est une surface sensible active (13),
- le prisme (8) étant disposé sous l'élément de recouvrement (2) de telle sorte que la surface sensible active (13) du prisme (8) est orientée de manière sensiblement parallèle à la face inférieure de l'élément de recouvrement (2),
- l'élément de recouvrement (2) présentant une zone sensible (2a) qui correspond à la zone de l'élément de recouvrement (2) au-dessus de la surface sensible active (13) et qui possède un facteur de transmission de 99% au maximum, 95% au maximum, 90% au maximum, 80% au maximum ou 50% au maximum,
- le prisme (8) et l'émetteur de lumière (5) étant disposés de telle sorte que la lumière émise par l'émetteur de lumière (5) est guidée à travers le prisme (8) et traverse la surface sensible active (13) et l'élément de recouvrement (2),
**caractérisé en ce que**
- la source de lumière de compensation (7) émet vers le récepteur optique (6) de la lumière qui est traitée dans le circuit d'analyse et
- le récepteur (6) est disposé de telle sorte que la lumière émise et réfléchie sur un objet situé à l'extérieur de l'élément de commande pénètre à travers la zone sensible (2a) de l'élément de recouvrement (2) et la surface sensible active (13) et est guidée à travers le prisme (8) jusqu'au récepteur (6), et le récepteur (6) est exécuté de telle sorte qu'une modification de la lumière réfléchie sur l'objet est détectée par le circuit d'analyse et interprétée comme une commutation.

2. Élément de commande optique selon la revendication 1, **caractérisé en ce que** l'élément de recouvrement (2) est opaque au rayonnement et comporte au moins une ouverture de sortie (10) à travers laquelle la lumière émise peut passer, l'ouverture de sortie (10) de l'élément de recouvrement (2) ayant une surface d'ouverture au moins deux fois plus petite que la surface de l'élément de recouvrement (2) et l'émetteur de lumière (5) et le prisme (8) étant disposés de préférence de telle sorte que la lumière émise par l'émetteur de lumière (5) sort à travers l'au moins une ouverture de sortie (10).

3. Élément de commande optique selon la revendication 1 ou 2, **caractérisé par** un élément diffuseur (4) permettant la diffusion de la lumière entrée, la lumière entrée dans l'élément diffuseur (4) sortant diffusée à travers l'ouverture de sortie (10) de l'élément de recouvrement (2) et permettant un rétroéclairage de l'élément de commande optique (100)

4. Élément de commande optique selon l'une des revendications précédentes, **caractérisé en ce que** l'élément de recouvrement (2) comporte plusieurs ouvertures de sortie (10) et, de préférence, au moins deux ouvertures de sortie (10) représentent, ensemble, un symbole, une lettre, un chiffre ou un pictogramme.

5. Élément de commande optique selon l'une des revendications précédentes, **caractérisé en ce que** la somme des surfaces d'ouverture des ouvertures de sortie (10) représente au maximum 30 pour cent de la surface de l'élément de recouvrement (2), de préférence au maximum 20 pour cent, 10 pour cent, 7 pour cent, 5 pour cent, 3 pour cent ou 2 pour cent.

6. Élément de commande optique selon l'une des revendications précédentes, **caractérisé en ce que** la somme des surfaces d'ouverture des ouvertures de sortie (10) est égale au maximum à 10 mm2, 7 mm2, 5 mm2, 3 mm2 ou 2 mm2.

7. Élément de commande optique selon l'une des revendications précédentes, **caractérisé en ce qu'**au moins une des ouvertures de sortie (10) a la forme d'un symbole, d'un chiffre, d'une lettre ou d'un pictogramme.

8. Élément de commande optique selon l'une des revendications précédentes, **caractérisé par** une source lumineuse supplémentaire (1) pour l'éclairage de l'élément de commande optique (100), la source lumineuse (1) étant disposée de telle sorte que la lumière qu'elle émet est diffusée de manière diffuse dans l'élément diffuseur (4) et est guidée ensuite à travers le prisme (8) jusqu'à l'ouverture de sortie (10) de l'élément de recouvrement (2).

9. Élément de commande optique selon l'une des revendications 1 à 8, **caractérisé en ce que** la source lumineuse (1) émettant de la lumière est utilisée pour le rétroéclairage de l'élément de commande optique (100), une partie de la lumière émise par l'émetteur de lumière (5) étant, de préférence, diffusée de manière diffuse dans l'élément diffuseur (4) avant que la partie diffusée de la lumière sorte à travers l'ouverture de sortie (10) de l'élément de recouvrement (2).

10. Élément de commande optique selon l'une des revendications précédentes, **caractérisé en ce que** le prisme (8) est disposé en forme de coin, une des surfaces latérales (12) étant disposée de manière sensiblement parallèle à l'élément de recouvrement (2) et, de préférence, l'émetteur de lumière (5) et/ou le récepteur optique (6) étant placé/s sur un des côtés du prisme (8) en forme de coin.

11. Élément de commande optique selon la revendication 10, **caractérisé en ce que** le prisme (8) est un prisme droit (8) avec une surface de base triangulaire, deux surfaces latérales (12) formant un angle droit et une de ces surfaces latérales (12) étant disposée de manière parallèle à l'élément de recouvrement (2) et l'émetteur de lumière (5) et/ou le récepteur optique (6) étant placé/s sur l'autre surface latérale (12).

12. Élément de commande optique selon l'une des revendications précédentes, **caractérisé en ce que** la source lumineuse de compensation (7) est exécutée en tant que diode électroluminescente qui émet de la lumière jusqu'au récepteur optique (6) de préférence à travers le prisme (8).

13. Élément de commande optique selon la revendication précédente, **caractérisé en ce que** le circuit d'analyse comprend un circuit de compensation qui permet de détecter la position et/ou le déplacement d'un objet à proximité de l'ouverture de sortie (10) de l'élément de recouvrement (2).

14. Élément de commande optique selon la revendication précédente, **caractérisé en ce que** l'élément de recouvrement (2) comporte plusieurs ouvertures de sortie (10) et la lumière émise par un premier émetteur de lumière (5) sort à travers une première ouverture de sortie (10) et la lumière émise par un second émetteur de lumière (5) sort à travers une seconde ouverture de sortie (10).

15. Élément de commande optique selon la revendication précédente, **caractérisé en ce que** le facteur de transmission de l'élément de recouvrement (2) est de 20% au maximum, 15% au maximum, 10% au maximum, 5% au maximum ou 2% au maximum.

16. Procédé de détection optoélectronique du déplacement et/ou de la position d'un objet au moyen d'un élément de commande optique (100) selon l'une des revendications précédentes, comprenant les étapes suivantes :
- émission d'un rayonnement lumineux par au moins un émetteur de lumière (5),
- guidage de la lumière émise à travers le prisme (8) et l'ouverture de sortie (10) de l'élément de recouvrement (2), la lumière traversant l'ouverture de sortie (10),
- réception de lumière réfléchie à travers l'ouverture de sortie (10) en raison d'un objet déplacé ou positionné à proximité de l'ouverture de sortie (10) à l'extérieur de l'élément de commande (100),
- guidage du rayonnement réfléchi sur l'objet à travers le prisme (8) jusqu'au récepteur optique (6),
- analyse du signal d'entrée optique au niveau du récepteur (6) au moyen d'un circuit d'analyse pour déterminer le déplacement et/ou la position de l'objet.
